# EUROPÄISCHE PATENTANMELDUNG

(11) **EP 0 590 456 A1**
(43) Veröffentlichungstag der Anmeldung: **06.04.1994**
(21) Anmeldenummer: 93115083.3
(22) Anmeldetag: 20.09.1993
(51) Int. Cl.: C04B 35/00, C04B 35/64, H01L 39/24

(54) **Verfahren zur Herstellung von Formkörpern aus oxidkeramischen Hochtemperatur-Supraleitern**

(30) Priorität: 30.09.1992 DE 4232900
(71) Anmelder: HOECHST AKTIENGESELLSCHAFT, D-65929 Frankfurt am Main (DE)
(72) Erfinder: Becker, Winfried, Dr., D-65817 Eppstein (DE); Bock, Joachim, Dr., D-50374 Erfstadt (DE); Elschner, Steffen, Dr., D-65527 Niedernhausen (DE)

(57) **Zusammenfassung**

Bei dem Verfahren zur Herstellung von Formkörpern aus oxidkeramischen Hochtemperatur-Supraleitern wird ein oxidkeramisches supraleitendes Pulver oder eine Mischung von Oxiden, Carbonaten und/oder Nitraten der die supraleitenden Verbindung bildenden Metalle im stöchiometrischen Verhältnis zu einem Formkörper geformt. Die Sinterung des Formkörpers und/oder die Bildung der supraleitenden Verbindung wird mit elektrischem Strom durchgeführt, der durch den Formkörper geleitet wird. Bevorzugt wird der elektrische Strom in der gewünschten späteren supraleitenden Stromrichtung durch den Formkörper geleitet. Mit dem Verfahren können Formkörper mit Textur hergestellt werden, die eine hohe Stromdichte haben.

## Beschreibung

Die vorliegende Erfindung betrifft ein Verfahren zur Herstellung von Formkörpern aus oxidkeramischen Hochtemperatur-Supraleitern, bei dem ein oxidkeramisches supraleitendes Pulver oder eine Mischung von Oxiden, Carbonaten und/oder Nitraten der die supraleitende Verbindung bildenden Metalle im stöchiometrischen Verhältnis zu einem Formkörper geformt wird.

Keramische Supraleiter gelten als aussichtsreiche Materialien für Bauteile oder Werkstücke im Bereich der Elektrik und Elektronik, da sie zum Teil hohe kritische Temperaturen haben, so daß eine Kühlung mit teurem flüssigem Helium nicht erforderlich ist. Voraussetzung für eine wirtschaftliche breite Anwendung ist eine hohe kritische Stromdichte J_{C}.

Es gibt bereits Verfahren zur Herstellung von Formkörpern aus supraleitendem oxidkeramischem Material, die hohe kritische Stromdichten haben. So können zum Beispiel supraleitende Schichten auf einkristallinem Strontiumtitanat abgeschieden werden, indem die Metalle verdampft und die Oxide in situ gebildet werden. Mit diesem Verfahren werden kritische Stromdichten von 10⁶ A/cm² erreicht. Es hat aber den Nachteil der hohen Herstellkosten, der begrenzten Leiterlänge, der geringen absoluten Ströme und der nicht universellen Verwendbarkeit. Ferner ist die Herstellung von supraleitenden Drähten nach der "Pulver-im-Rohr-Methode" möglich, bei der ebenfalls hohe Stromdichten von über 10⁴ A/cm² erreicht werden. Bei dieser Methode wird ein supraleitendes Pulver in ein dünnes Silberrohr eingebracht und dann wird das Rohr gezogen. Mit diesem Verfahren ist nur die Herstellung von Drähten, aber nicht die Herstellung von beliebigen Formkörpern, wie zum Beispiel Bändern oder kompakten Bauteilen möglich.

Aus der DE-A-4 003 542 ist ein Verfahren zur Herstellung von Formkörpern aus supraleitendem oxidkeramischem Material mit hohen kritischen Stromdichten bekannt, bei dem Pulver verwendet werden, die aus Mischungen unterschiedlich geformter Teilchen mit bestimmten durchschnittlichen Größen bestehen. Diese Pulver werden dann in bekannter Weise zu einer formbaren Masse aufbereitet und nach Verfahren, bei denen Scherkräfte auf die formbare Masse ausgeübt werden, zu einem Grünkörper verformt, gesintert und ggf. getempert.

Bei der Herstellung von Formkörpern aus Pulvern mit Teilchen ohne spezielle Form und Größe nach in der technischen Keramik herkömmlichen Formgebungs-Verfahren erreicht man aber bisher nur geringe kritische Stromdichten von nicht über 1000 A/cm². Meistens liegen die gemessenen Werte noch tiefer und erreichen nicht einmal Werte von 500 A/cm². Verantwortlich für die niedrigen kritischen Stromdichten sind die geringe Sinterdichte und die "weak-links" in den keramischen Supraleitern.

In der EP-A-0 362 492 wird ein Verfahren zur Herstellung eines Hochtemperatur-Supraleiters der Zusammensetzung Bi₂(Sr,Ca)₃Cu₂O₈₊ₓ beschrieben, bei dem die Oxide und/oder Carbonate des Bismuts, Strontiums, Calciums und Kupfers im stöchiometrischen Verhältnis intensiv gemischt werden, die Mischung erhitzt wird, bis eine homogene Schmelze vorliegt, die Schmelze in Kokillen vergossen wird, der Gußkörper nach dem Erstarren der Schmelze aus den Kokillen genommen wird und bei bestimmten Temperaturen in Luft und anschließend in Sauerstoffatmosphäre getempert wird. Es bildet sich ein polykristallines, regelloses Gefüge des Hochtemperatur-Supraleiters aus.

Nach den Untersuchungen von D. Dimos et al., Phys. Rev. Lett. 61, 219 (1988) und J. Mannhart, J. Supercond. 3, 281 (1990) hängt die kritische Transportstromdichte bei YBa₂Cᵤ₃O_{7-δ} empfindlich vom Winkel zwischen den kristallographischen Achsen einzelner Kristalle ab. Ähnliches erwartet man auch in allen anderen oxidkeramischen Hochtemperatur-Supraleitern Je kleiner der Winkel ist, um so höher ist die kritische Transportstromdichte. Am günstigsten ist eine Ausrichtung der kristallographischen abEbenen längs der supraleitenden Stromrichtung.

Aufgabe der vorliegenden Erfindung ist die Bereitstellung eines Verfahrens der eingangs genannten Art, bei dem man ohne von Pulvern mit Teilchen bestimmter Form und Größe ausgehen zu müssen sowie mit geringerem Energieaufwand und niedrigeren Herstellkosten oxidkeramische Hochtemperatur-Supraleiter beliebiger Form herstellen kann und mit dem die Erreichung hoher kritischer Stromdichten möglich ist. Insbesondere soll ein Verfahren geschaffen werden, das es ermöglicht, supraleitende oxidkeramische Formkörper mit Textur, d.h. einer Ausrichtung der Kristalle in der supraleitenden Stromrichtung, herzustellen, deren kritische Stromdichte über 1000 A/cm² liegt.

Ausgehend von dem eingangs genannten Verfahren wird die Aufgabe dadurch gelöst, daß das Sintern des Formkörpers und/oder das Tempern zur Bildung der supraleitenden Verbindung mit elektrischem Strom durchgeführt wird, der durch den Formkörper geleitet wird.

Bevorzugt wird der elektrische Strom in der gewünschten späteren supraleitenden Stromrichtung durch den Formkörper geleitet.

Sofern bei der Formgebung bereits von einem supraleitenden Pulver ausgegangen wird und dies bei der Formgebung seine supraleitenden Eigenschaften beibehält, wird der Formkörper mit Hilfe des durch ihn geleiteten elektrischen Stroms gesintert. Sofern bei der Formgebung von Mischungen der Oxide, Carbonate und/oder Nitrate der die supraleitende Verbindung bildenden Metalle ausgegangen wird, und bei der Formgebung bereits die erforderliche Dichte des Formkörpers erreicht wird, z.B. beim Schmelzguß, wird mit Hilfe des durch den Formkörper geleiteten Stromes die supraleitende Verbindung hergestellt. Es kann jedoch durch den elektrischen Strom auch beides, Sintern und Bildung der supraleitenden Verbindung, erreicht werden, wenn bei der Formgebung kein ausreichend dichter Formkörper gebildet wird und die supraleitenden Eigenschaften verschlechtert werden oder verloren gehen.

In allen Fällen kann durch die erfindungsgemäße Aufheizung des Formkörpers durch den durch ihn geleiteten Strom eine Ausrichtung der Kristalle erreicht werden. Die den elektrischen Strom besser leitenden kristallographischen ab-Ebenen wachsen längs der Flußrichtung des Stromes. In einer bevorzugten Ausführungsform wird die Temperatur des Formkörpers über die zur Sinterung und/oder Bildung der supraleitenden Verbindung erforderliche Temperatur erhöht, indem eine weitere Erhöhung der Stromstärke des durch den Formkörper fließenden Stromes erfolgt, und der Formkörper wird ausreichend lang auf dieser Temperatur gehalten. Dadurch wird ein Formkörper mit ausgeprägter Textur erhalten, dessen kritische Stromdichte weit über 1000 A/cm² liegt.

Das Verfahren ist auf alle Hochtemperatur-Supraleiter anwendbar, bei denen beim Tempern oder Sintern partielle Schmelzen auftreten können. Beispiele für geeignete Materialien sind YBa₂Cu₃O_{7-δ}, Bi₂(Sr,Ca)₂CuO₆₊ₓ, Bi₂(Sr,Ca)₃Cu₂O₈₊ₓ, Bi₂(Sr,Ca)₄Cu₃O₁₀₊ₓ, Tl₂Ca₂Ba₂Cu₃O₁₀, Tl₂CaBa₂Cu₂O₈, und Tl₂Ba₂CuO₆.

Zur Formgebung können alle herkömmlichen Verfahren angewandt werden, sofern der formbaren Masse nicht zu hohe Mengen an organischen Stoffen zugesetzt werden, die die Leitfähigkeit des Formkörpers zu stark erniedrigen. So kann zum Beispiel von einem schmelzgegossenen Formkörper ausgegangen werden. Zu seiner Herstellung wird eine Mischung von Oxiden, Carbonaten und/oder Nitraten der die supraleitende Verbindung bildenden Metalle im stöchiometrischen Verhältnis intensiv gemischt. Die Mischung wird solange auf Temperaturen von 800 bis 1100°C erhitzt, bis eine homogen Schmelze vorliegt. Die Schmelze wird in Kokillen gegossen, darin erstarren gelassen, und anschließend wird der Gußkörper aus den Kokillen herausgenommen. Der Gußkörper kann, falls erforderlich, durch mechanische Verfahren auf die gewünschten Abmessunger gebracht werden. Das Material des Gußkörpers weist eine Bruttozusammensetzung auf, die ggf. mit Ausnahme des Sauerstoffgehalts der eines oxidkeramischen Supraleiters entspricht.

Bei einer anderen Formgebung kann von einem oxidkeramischen Pulver, das bereits supraleitend ist, ausgegangen werden, das z.B. durch Trockenpressen zu einem Grünkörper geformt wird.

Die für die Stromzuführung notwendigen Kontakte können entweder nach der Formgebung am Formkörper angebracht werden oder bereits bei der Formgebung mit dem oxidkeramischen Material verbunden werden. Bei der Formgebung durch Schmelzguß können z.B. die Kontakte teilweise mit der Schmelze umhüllt werden, wenn sie in die Kokillen gegossen wird. Die Kontakte müssen aus einem Material bestehen, das den elektrischen Strom gut leitet und die beim erfindungsgemäßen Verfahren auftretenden Temperaturen aushält. Silber und Gold sind bevorzugte Materialien.

Die für die Stromzuführung notwendigen Kontakte sind vorzugsweise so am Formkörper vorzusehen, daß der Strom in der gewünschten späteren supraleitenden Stromflußrichtung fließt, wenn sie an eine Stromquelle angeschlossen werden. Bei einem stabförmigen Formkörper z.B. sind die Kontakte an seinen Endflächen angebracht, bei einer Spule an der Zu- und Ableitung und bei einer Platte an den Stirnflächen.

Beim erfindungsgemäßen Verfahren kann Gleichstrom oder Wechselstrom verwendet werden. Die Stromstärke des durch den Formkörper geleiteten Stromswird erhöht, bis der Formkörper durch den Strom mindestens auf die zur Sinterung und/oder Bildung der supraleitenden Verbindung notwendige Temperatur aufgeheizt ist. Der Formkörper wird dann einige Zeit auf dieser Temperatur gehalten, und anschließend wird die Stromstärke auf Null erniedrigt, wodurch der Formkörper abkühlt.

Die Anfangsstromstärke, die Steigerung der Stromstärke sowie der höchste Wert der Stromstärke, d.h. die Stromstärke zum jeweiligen Zeitpunkt des Aufheizvorganges des Formkörpers, richten sich nach der Größe und dem spezifischen Widerstand des Formkörpers, nach dem angestrebten Temperaturverlauf des Formkörpers sowie nach dem jeweiligen oxidkeramischen Material, aus dem der Formkörper besteht. Je größer der Formkörper ist, desto höhere Stromstärken sind erforderlich. Je höher der spezifische Widerstand des Formkörpers ist, desto niedriger wird die jeweilige Stromstärke gewählt. Wird ein langsamer Temperaturanstieg gewünscht, so wird die Stromstärke langsam gesteigert. Der höchste Wert der Stromstärke richtet sich nach der für das jeweilige keramische Material nötigen Sintertemperatur oder nach der für die Umwandlung in die supraleitende Verbindung notwendigen Temperatur. Vorzugsweise wird die Stromstärke so weit gesteigert, daß diese Temperaturen noch überstiegen werden, um eine gute Ausrichtung der Kristalle und damit sehr hohe Stromdichten zu erreichen.

Bei einer Ausführungsform des erfindungsgemäßen Verfahren wird die Stromstärke langsam in dem Maß erhöht, in dem der spezifische Widerstand des Formkörpers abnimmt. Dadurch wird ein langsamer Temperaturanstieg des Formkörpers erreicht. Je nach der Größe der Formkörper kann die Stromstärke von 100 mA bis auf 1000 A erhöht werden.

Der Formkörper erwärmt sich mit steigender Stromstärke bis auf Rotglut, typischerweise können je nach Material Temperaturen von Raumtemperatur bis zu 1000°C durchlaufen werden. Bei Bi₂(Sr,Ca)₃Cu₂O₈₊ₓ beträgt die Temperatur gegen Ende des Aufheizvorganges etwa 840 bis 860°C. Bei YBa₂Cu₃O_{7-δ} muß die Temperatur höher sein, etwa 900 bis 950°C.

Nach Erreichen der jeweils erforderlichen Temperatur wird der Strom zur Vervollständigung der Sinterung bzw. Umwandlung in die supraleitende Verbindung sowie zur Ausrichtung der Kristalle nur noch so variiert, daß der Formkörper auf dieser Temperatur gehalten wird. Diese Zeit kann je nach Material und Größe des Formkörpers und dem gewünschten Ausmaß der Ausrichtung der Kristalle längs der Stromrichtung 2 bis 100h, bevorzugt 40 bis 70h betragen. Danach wird die Stromstärke allmählich erniedrigt, wobei sich der Formkörper abkühlt. Dieser Vorgang kann 2 bis 50h, bevorzugt 4 bis 12h betragen.

Es ist bei dem erfindungsgemäßen Verfahren auch möglich, den Formkörper in einem Temperofen zu erwärmen, bevor und während der elektrische Strom durch den Formkörper geleitet wird. So kann der Formkörper im Temperofen auf eine Temperatur erhitzt werden, die knapp unterhalb der zur Sinterung oder Bildung der supraleitenden Verbindung notwendigen Temperatur liegt. Die weitere Aufheizung des Formkörpers auf die erforderliche Temperatur und das Halten des Formkörpers auf dieser Temperatur erfolgt dann durch den durch den Formkörper geleiteten Strom, wobei die obigen Angaben zur Temperatur am Ende des Aufheizvorgangs und zu den Zeiten entsprechend gelten.

Bei einer anderen Ausführungsform wird ein Gleichstrom durch den Formkörper geleitet und die Stromstärke so schnell erhöht, daß sich in der Nähe der Anode eine eng begrenzte glühende Zone aus einer partiellen Schmelze im Formkörper bildet. Diese Zone wandert bei etwa gleichbleibender Stromstärke entlang des Formkörpers zur Kathode, so daß alle Teile des Formkörpers von der glühenden Zone durchlaufen werden. Der Formkörper zeigt nach der Abkühlphase eine deutliche durch das Zonenschmelzen gebildete Textur.

Sofern von einer Mischung der Oxide, Carbonate und/oder Nitrate der die supraleitende Verbindung bildenden Metalle im stöchiometrischen Verhältnis bei der Formgebung ausgegangen wurde, wird die Stromstärke, nachdem die Zone aus einer partiellen Schmelze den Formkörper durchlaufen hat, weiter gesteigert, bis der Formkörper die zur Bildung der supraleitenden Verbindung notwendige Temperatur erreicht hat. Wie weiter oben beschrieben, wird der Formkörper dann auf dieser Temperatur gehalten und danach abgekühlt.

Die Erfindung wird an Hand der folgenden Beispiele und der photographischen Aufnahmen näher erläutert.

### Beispiel 1

Es wurde ein Stab mit der nominalen Zusammensetzung Bi₂Sr₂CaCu₂Oₓ von 10 cm Länge und 0,8 cm Durchmesser durch Schmelzguß hergestellt. Dabei wurde mit zwei Ausnahmen nach dem in der EP-A-0 364 492 beschriebenen Verfahren vorgegangen. An den Stirnflächen der Kokillen wurden ringförmige Silberbleche angeordnet, so daß die Schmelze nach dem Erstarren fest mit den Silberkontakten verbunden war. Nach der Entfernung des schmelzgegossenen Stabes aus der Kokille wurden nicht die in der EP-A-0 362 492 beschriebenen Temperschritte durchgeführt.

Der Stab wurde in ein mit einem Thermometer versehenes Quarzrohr eingebracht und über die an seinen Enden befindlichen Silberkontakten mit einer Gleichstromquelle verbunden. Der spezifische Widerstand zu Beginn des Versuches betrug 625 mΩ·cm. Der Strom durch den Stab wurde langsam im Lauf von 10 Tagen von 1A auf 30A gesteigert. Der Stab erwärmte sich dabei auf 860°C und der spezifische Widerstand sank auf 9,2 mΩ·cm. Der Stab wurde noch 60 Stunden auf dieser Temperatur gehalten, wobei der Strom langsam auf 32 A gesteigert wurden mußte. Anschließend wurde der Strom mit einer konstanten Abnahme von 3 A/h gesenkt, wobei der Stab abkühlte. Der aus der supraleitenden Verbindung Bi₂Sr₂CaCu₂O_{8,15} bestehende Stab hatte eine kritische Temperatur von 90 K und eine kritische Stromdichte von 11300 A/cm² bei 77 K.

### Beispiel 2

Wie in Beispiel 1 beschrieben, wurde ein Stab mit gleicher nominaler Zusammensetzung und Abmessung durch Schmelzguß hergestellt, in ein Quarzrohr eingeführt und über seine Silberkontakte mit einer Gleichstromquelle verbunden. Der Gleichstrom wurde diesmal innerhalb von 5h auf 15 A erhöht. Dabei erwärmte sich der Stab auf ca. 700°C. An der Anode bildete sich eine ca. 2 mm breite Zone mit einer über 800°C liegenden Temperatur. Die Zone wanderte im Verlauf von 5h zur Kathode und kühlte dort ab. Anschließend wurde der Strom langsam auf 30 A gesteigert, wobei der gesamte Stab eine Temperatur von ca. 860°C annahm. Die weitere Vorgehensweise entsprach der in Beispiel 1 beschriebenen.

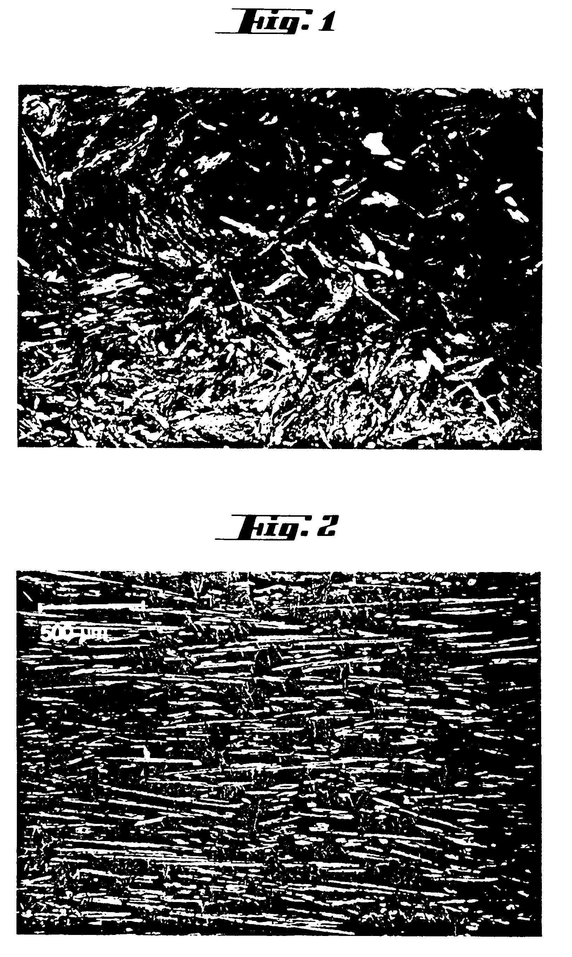

Die photographischen Aufnahmen zeigen keramographische Schliffe vor und nach der erfindungsgemäßen Behandlung. Bild 1 zeigt, daß die Primärkristallite vor der Behandlung regellos angeordnet sind. Bild 2 zeigt, daß nach der Behandlung längs der Stromrichtung ausgerichtete Supraleiterkristalle vorliegen.

## Patentansprüche

1. Verfahren zur Herstellung von Formkörpern aus oxidkeramischen Hochtemperatur-Supraleitern, bei dem ein oxidkeramisches supraleitendes Pulver oder eine Mischung von Oxiden, Carbonaten und/oder Nitraten der die supraleitende Verbindung bildenden Metalle im stöchiometrischen Verhältnis zu einem Formkörper geformt wird, dadurch gekennzeichnet, daß das Sintern des Formkörpers und/oder das Tempern des Formkörpers zur Bildung der supraleitenden Verbindung mit elektrischem Strom durchgeführt wird, der durch den Formkörper geleitet wird.

2. Verfahren nach Anspruch 1, dadurch gekennzeichnet, daß der elektrische Strom in der gewünschten späteren supraleitenden Stromrichtung durch den Formkörper geleitet wird.

3. Verfahren nach Anspruch 1 oder 2, dadurch gekennzeichnet, daß die Stromstärke des durch den Formkörper geleiteten Stromes erhöht wird, bis der Formkörper mindestens auf die zur Sinterung und/oder Bildung der supraleitenden Verbindung notwendige Temperatur aufgeheizt ist, der Formkörper durch den durch ihn geleiteten Strom auf dieser Temperatur über eine Zeit von 2 bis 100 h gehalten wird, und die Stromstärke zur Abkühlung des Formkörpers auf Null erniedrigt wird.

4. Verfahren nach einem der Ansprüche 1 bis 3, dadurch gekennzeichnet, daß zur Formgebung eine Mischung von Oxiden, Carbonaten und/oder Nitraten der die supraleitende Verbindung bildenden Metalle im stöchiometrischen Verhältnis zur homogenen Schmelze erhitzt wird, die Schmelze in Kokillen gegossen wird und der Formkörper nach dem Erstarren der Schmelze aus den Kokillen entnommen wird.

5. Verfahren nach einem der Ansprüche 1 bis 3, dadurch gekennzeichnet, daß zur Formgebung ein oxidkeramisches supraleitendes Pulver zu einer formbaren Masse aufbereitet und dann zu einem Grünkörper geformt wird.

6. Verfahren nach Anspruch 5, dadurch gekennzeichnet, daß die Formgebung durch Trockenpressen erfolgt.

7. Verfahren nach einem der Ansprüche 1 bis 6, dadurch gekennzeichnet, daß der Formkörper auf Temperaturen im Bereich von 800 bis 1000°C aufgeheizt wird.

8. Verfahren nach einem der Ansprüche 1 bis 7, dadurch gekennzeichnet, daß der Formkörper 40 bis 70 h auf der Temperatur gehalten wird.

9. Verfahren nach einem der Ansprüche 1 bis 8, dadurch gekennzeichnet, daß der Formkörper in einem Ofen auf Temperaturen erwärmt wird, die unterhalb der zur Sinterung oder Bildung der supraleitenden Verbindung mindestens notwendigen Temperatur liegen, bevor und während der elektrische Strom durch den Formkörper geleitet wird.

10. Verfahren nach einem der Ansprüche 1 bis 9, dadurch gekennzeichnet, daß die Stromstärke langsam erhöht sowie langsam auf Null erniedrigt wird.

11. Verfahren nach einem der Ansprüche 1 bis 9, dadurch gekennzeichnet, daß ein Gleichstrom durch den Formkörper geleitet wird, dessen Stromstärke so schnell erhöht wird, daß sich im Formkörper an der Anode eine Zone aus einer partiellen Schmelze bildet und diese Stromstärke beibehalten wird, bis die Zone durch den Formkörper bis zur Kathode gewandert ist.
